# FASCICULE DE BREVET EUROPEEN

(11) **EP 2 417 279 B1**
(45) Date de publication et mention de la délivrance du brevet: **22.07.2020**
(21) Numéro de dépôt: 10723659.8
(22) Date de dépôt: 12.04.2010
(51) Int. Cl.: H01J 37/34, C23C 4/08, C23C 14/06, C23C 14/18, C23C 4/067, C23C 14/34, C23C 4/137

(54) **CIBLE À BASE DE MOLYBDÈNE ET PROCÉDÉ D'ÉLABORATION PAR PROJECTION THERMIQUE D'UNE CIBLE**
TARGET AUF BASIS VON MOLYBDÄN UND HERSTELLUNGSVERFAHREN MIT THERMISCHER PROJEKTION EINES TARGETS
TARGET BASED ON MOLYBDENUM AND PRODUCTION METHOD WITH THERMAL PROJECTION OF A TARGET

(30) Priorité: 10.04.2009 FR 0952392
(43) Date de publication de la demande: 15.02.2012
(73) Titulaire: Saint-Gobain Coating Solutions, 84093 Avignon Cedex 9 (FR)
(72) Inventeur: BILLIERES, Dominique, F-84450 Saint-Saturnin les Avignon (FR)
(74) Mandataire: Saint-Gobain Recherche
(86) Numéro de dépôt international: PCT/FR2010/050703
(87) Numéro de publication internationale: WO 2010/116111

(56) Documents cités:
- EP-A- 1 748 491
- WO-A-2007/141174
- DE-A1- 4 339 345
- US-A- 4 619 697
- US-A1- 2005 230 244
- US-A1- 2006 233 965
- US-A1- 2008 138 620
- US-A1- 2008 271 779

## Description

La présente invention concerne un procédé d'élaboration d'une cible destinée à être utilisée dans les procédés de dépôt sous vide, en atmosphère neutre ou réactive, notamment par pulvérisation cathodique assistée par champ magnétique, par pulvérisation ou par source d'ions.

Selon un autre aspect de l'invention, elle vise également une cible à base de molybdène, obtenue éventuellement par la mise en œuvre dudit procédé, ainsi que l'utilisation d'une telle cible en vue de l'obtention de couches à base du matériau pulvérisé à partir de ladite cible, ainsi qu'une composition du composé permettant l'élaboration de ladite cible par le procédé objet de l'invention.

On connaît diverses techniques conduisant à la fabrication de cibles dont certaines à partir de la mise en forme de poudres. Ainsi, les cibles en question peuvent résulter d'un processus de fonderie, de frittage de poudres suivi de techniques de mise en forme, souvent à chaud puis d'assemblage sur un support, ou directement d'assemblage de segments frittés, ou moins classiquement d'une technique de projection thermique, et plus particulièrement d'une technique de projection par torche plasma (ou communément appelée plasma spray en anglais).

Ces cibles sont destinées à être mises en œuvre au sein de procédés couramment employés à l'échelle industrielle pour le dépôt de couches minces, notamment sur substrat verrier, comme par exemple le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée.

Dans le cas spécifique d'une cible destinée au dépôt de molybdène, on utilise un procédé de dépôt dit « non-réactif » où le plasma est composé uniquement d'un gaz assurant la pulvérisation, préférentiellement un gaz noble de type Ar, Kr, Xe ou Ne. Ce procédé est mis en œuvre pour des substrats de grande dimension et peut permettre le dépôt de couches minces sur des substrats, par exemple des feuilles de verre plat, de plus de 6 m de côté.

Ces cibles sont de géométrie plane ou tubulaire.

Les cibles planes offrent l'avantage de pouvoir être intégrées dans des cathodes d'architecture relativement simple par rapport aux cathodes dédiées aux cibles rotatives qui sont beaucoup plus complexes, par contre les cibles planes ont un taux d'utilisation qui est généralement inférieur ou égal à 50 %, ce qui n'est pas le cas des cibles rotatives qui ont un taux d'utilisation nettement supérieur à 50 %.

Les documents US 2008 271779 A1 et DE 43 39 345 A1 décrit des cibles en molybdène.

Dans le cas spécifique des couches minces en molybdène, ce dernier étant un métal particulièrement onéreux, on utilise préférentiellement des cibles rotatives, de géométrie cylindrique, tel que décrit dans le brevet US4356073 car ces cibles présentent un rendement matière (qui représente la proportion de matière pulvérisée par rapport à la quantité de matière disponible sur la cible pour réaliser une couche mince) supérieur à 70%, préférentiellement supérieur à 75%. Néanmoins, on connait aussi d'autres géométries variées de cibles magnétron : planes (disques, carrées, rectangulaires) et l'invention est applicable également à d'autres géométries que le cylindre.

On a relevé les données bibliographiques suivantes pour le molybdène pur :
- Densité [g/cm³] 10.28
- Expansion thermique [K-1] 4.8 x 10-6
- Module de Young [N/mm²] 324
- Résistivité électrique [µ.Ohm.cm] 5,34
- Conductivité thermique [W/mK] 139
- Point de fusion [°C] 2630

En outre, il existe également d'autres procédés de dépôt sous vide de molybdène alternatifs à la pulvérisation magnétron et utilisant une cible : il s'agit de la pulvérisation par laser (pulsé ou non : ablation laser), de la pulvérisation par faisceau d'ions par exemple. Ces procédés peuvent également tirer avantage de l'utilisation d'une cible selon l'invention.

Concernant plus particulièrement les cibles magnétrons en molybdène ou autres métaux réfractaires, de nombreuses inventions ont été déposées, portant sur les procédés suivants et faisant l'objet des demandes de brevet énumérées ci-dessous :
- Demandes EP1784518 - US20080193798 -WO2006/041730 :
   Pressage puis frittage d'un lingot ou d'une préforme (sous une pression de 200 à 250 MPa et à une température de 1780 à 2175 °C) puis mise en forme à chaud (environ 900 °C) de cette préforme par laminage ou extrusion, ou forgeage. Généralement ce procédé comprend également un traitement thermique sous hydrogène ou atmosphère réductrice pour réduction du taux d'oxyde dans la cible, ainsi qu'éventuellement un recuit de relaxation de contraintes
- On connaît par ailleurs par la demande WO2006117145 la construction de tout ou partie, ou la restauration de cibles par projection de type « cold spray », qui consiste en la projection d'un mélange gaz + poudre porté à vitesse supersonique, la poudre n'étant pas portée à un état de fusion, ce qui diffère des procédés de projection thermique.

Document DE 43 39 345 A1 décrit la projection plasma pour obtenir des couches en molybdènes. US 2008/0271779 A1 divulgue un cible en molybdène réalisé par projection froid.

Bien que ces documents couvrent aussi la réalisation par ces méthodes de cibles de compositions diverses, les cibles de molybdène pur présentent usuellement les propriétés suivantes :
- pureté > 99.95 %
- densité > 95 % de la densité théorique
- microstructure à grains fins.

Les cibles ayant ces caractéristiques sont pulvérisées pour obtenir des couches minces qui sont utilisées par exemple en tant qu'électrode pour des applications photovoltaïques à base de matériau actif appartenant à la famille des chalcopyrites (CIS, CIGS par exemple). Le molybdène présente un bon compromis entre conductivité électrique (inférieure à 30 µOhm.cm), résistance à la température (propriétés réfractaires : point de fusion : 2610°C) et résistance élevée à la sélénisation. En effet, le molybdène résiste bien à l'atmosphère riche en sélénium durant l'étape de dépôt du CIS ou du CIGS, le molybdène réagissant en surface avec le sélénium pour former une couche passivante de MoSe₂ sans perdre ses propriétés de conduction électrique ou encore pour des applications de type TFT (thin film transistor), qui requièrent des densités de défauts (appelés communément « pinholes ») extrêmement faibles. On cite notamment des densités maximales de pinholes de 500 /m² de taille comprise entre 1 et 5 µm. De tels niveaux de qualité sont accessibles uniquement si le procédé de pulvérisation est vierge de toute instabilité électrique de type arcing. Ceci est notamment possible lorsque la cible est exempte de porosité significative, avec une densité d'au moins 90%.

Bien que les procédés d'obtention de cible par plasma spray soient connus pour ne pas permettre d'atteindre des propriétés similaires à celles obtenues précédemment, la présente invention s'intéresse à un procédé de réalisation d'une cible à base de molybdène par plasma spray offrant des performances en utilisation au moins égales, voire supérieures à celles obtenues par des procédés de fabrication traditionnelle.

A cet effet, le procédé de réalisation selon la revendication 1, objet de l'invention, d'une cible par projection plasma au moyen d'une torche plasma, ladite cible étant en molybdène, est caractérisé en ce qu'on projette par projection thermique sur au moins une portion de surface de la cible, au moins une fraction dudit composé sous forme d'une composition de poudre dudit composé, sous atmosphère de gaz inerte, et en ce qu'on utilise des jets refroidisseurs cryogéniques puissants dirigés vers la cible pendant sa construction et répartis autour de la torche.

On rappelle que sont par définition considérés comme cryogéniques des fluides dont la température est inférieure ou égale à -150°C.

L'utilisation pendant la projection plasma de jets refroidisseurs cryogéniques (jets de liquide cryogéniques ou jets mixtes gaz/liquide cryogéniques ou jets de gaz cryogéniques) permet d'améliorer la qualité de la cible en assurant une double fonction :
- un refroidissement immédiat de la zone projetée annihilant par la même toute possibilité d'oxydation ou de nitruration partielle (par la présence même faible de traces d'oxygène ou d'azote dans l'enceinte) du matériau projeté
- un nettoyage puissant de la surface projetée afin d'assurer une excellente cohésion propre entre les particules et passes successives

Par ailleurs, l'utilisation d'une torche plasma et d'un mélange de gaz plasmagène permettent d'obtenir une forte réduction en vol des particules de poudre projetées, réduisant ainsi le taux d'oxyde présent dans la cible comparativement à celui présent dans la poudre (T_{oc} < Tₒₚ où T_{oc} est le taux d'oxygène présent dans la cible et Tₒₚ est le taux d'oxygène présent dans la poudre)

D'autre part, le procédé objet de l'invention comporte les aspects suivants, plus classiques :
- on réalise un mouvement relatif entre la torche plasma et la cible,
- on réalise une préparation de surface de la cible préalablement au dépôt dudit composé,
- la préparation de surface comporte une étape de jet d'abrasifs (communément appelé sablage) sur la portion de surface de la cible concernée ou alternativement une étape d'usinage de stries adaptées à l'accrochage de la sous-couche,
- la préparation de surface comporte ensuite la projection d'une couche d'un matériau d'accrochage (sous-couche) au niveau de la portion de surface de la cible concernée,

Dans d'autres modes de réalisation de l'invention, on peut éventuellement avoir recours en outre à l'une et/ou à l'autre des dispositions suivantes :
- la projection du composé est réalisée au sein d'une enceinte ayant été purgée ou rincée puis remplie du gaz inerte, jusqu'à une pression pouvant aller de 50 mbars à 1100 mbars, de manière à créer en son sein une atmosphère appauvrie en oxygène (% O₂ < 5%)
- la projection thermique est réalisée par une torche plasma et en ce que le mélange de gaz plasmagène utilisé est réducteur (apte à réduire le taux de molybdène oxydé initialement présent dans la poudre), préférentiellement la composition du mélange plasmagène comportant plus de 10% d'Hydrogène ou un autre gaz plasmagène réducteur.
- on utilise une sous couche d'accrochage, cette dernière étant déposée avant projection thermique dudit composé au niveau de la portion de surface de la cible concernée.
- on procède à une régulation thermique de la cible lors de la projection plasma.
- on utilise une composition de poudre dudit composé projetée comportant des poudres de granulométrie 5 < D₁₀ <50 µm ; 25 µm < D₅₀ <100 µm et 40 µm < D₉₀ < 200 µm.
- le taux d'oxygène présent dans la cible sous forme d'oxyde est inférieur de plus de 5% relatifs à celui initialement présent dans la poudre de départ
- il comporte une étape subséquente de traitement thermique sous atmosphère réductrice visant à réduire le taux d'oxygène présent dans la cible à l'issue de l'étape de projection thermique
- on utilise plusieurs injecteurs dudit composé pour injecter en différents points du jet thermique différents matériaux pour lesquels on ajuste indépendamment les paramètres d'injection en fonction des matériaux injectés dans chaque injecteur.

Selon un autre aspect de l'invention, celle-ci vise une cible élaborée éventuellement par le procédé objet de l'invention et destinée à être utilisée dans un dispositif de pulvérisation cathodique, notamment assistée par champ magnétique, ou dans tout autre dispositif de pulvérisation sous vide à partir d'une cible, ladite cible comprenant majoritairement du molybdène.

A cet effet, la cible selon la revendication 6, objet de l'invention, d'épaisseur nominale (e), comprenant au moins un composé à base de molybdène, se caractérise en ce qu'elle présente :
- une microstructure lamellaire,
- un taux d'oxygène inférieur à 1000 ppm, préférentiellement inférieur à 600 ppm, et de manière encore plus préférentielle inférieur à 450 ppm
- une résistivité électrique inférieure à 5 fois, de préférence 3 fois, de préférence encore à 2 fois la résistivité électrique théorique du composé

Cette mesure de résistivité est réalisée par la méthode Van der Pauw (ASTM F76), la mesure relative de la résistivité est calculée par rapport à la valeur théorique à 20°C, du composé passif (ou de la donnée bibliographique) (rappel pour le molybdène, la valeur est de 5, 34 µOhm.cm)

Dans des modes de réalisation préférés de l'invention, on peut éventuellement avoir recours en outre à l'une et/ou à l'autre des dispositions suivantes :
- la cible est de géométrie plane
- la cible est de géométrie tubulaire.
- la cible comporte des surépaisseurs de matière à chacune de ses extrémités.
- la cible comprend une ou plusieurs pièces sur lesquelles le composé est déposé, ladite ou lesdites pièce(s) est ou sont soit un support plan adaptable sur une machine de pulvérisation soit des pièces intermédiaires liées ensuite sur ce support.
- les surépaisseurs sont de l'ordre de 25 à 50 % de l'épaisseur nominale de la couche de composé.
- la cible présente une densité supérieure à 85 %, préférentiellement supérieure à 90 %,
   (densité mesurée selon la norme ISO 5016)
- l'épaisseur nominale (e) est comprise entre 1 et 25 mm, préférentiellement comprise entre 6 et 14 mm.
- la cible présente une teneur en fer inférieure à 50 ppm, préférentiellement inférieure à 35 ppm.
- la cible présente une teneur en Ni inférieure à 20 ppm, préférentiellement inférieure à 10 ppm
- la cible présente une teneur en Cr inférieure à 50 ppm, préférentiellement inférieure à 20 ppm
- la cible présente une teneur en tungstène inférieure à 300 ppm, préférentiellement inférieure à 200 ppm
- la cible présente une pureté d'au moins 99,95 %.
- la cible est construite sur un matériau support offrant des caractéristiques compatibles avec les propriétés attendues d'une cible magnétron en utilisation (résistance mécanique suffisante, conductivité thermique suffisante, résistance à la corrosion par l'eau de refroidissement en utilisation de la cible, ...), comme par exemple du cuivre ou alliage cuivreux, ou en acier inoxydable austénitique, comme par exemple du X2CrNi18-9 ou du X2CrNiMo17-12-2

Dans des modes de réalisation préférés de l'invention, on peut éventuellement avoir recours en outre à l'une et/ou à l'autre des dispositions suivantes :
- la couche en molybdène présente une résistivité inférieure à 25µOhm.cm préférentiellement inférieure à 20 µOhm.cm Selon encore d'autre aspect de la divulgation, celle-ci vise un écran plat d'affichage, celui-ci pouvant être de technologie parmi les groupes suivants : TFT (Thin Film Transistor), LCD (Liquid Crystal Displays), PDP (Plasma Display Panels), OLED (Organic Light Emitting Diodes), ILED (Inorganic Light Emitting Diode Displays), ou encore FED (Field Emission Displays), ou encore un composant semiconducteur comportant au moins une couche à base de Mo ou de MoSi₂, ou encore il s'agit d'une couche en MoSi₂ qui est utilisée en tant que masque dans la fabrication de composant semiconducteur.

Selon encore un autre aspect de la divulgation, elle vise au moins une électrode formée d'une couche à base de molybdène obtenue à l'aide d'une cible telle que précédemment décrite (cette électrode étant utilisée au sein d'une cellule ou d'un module photovoltaïque.

Selon encore une autre caractéristique de la divulgation, celle-ci vise une couche de molybdène obtenue par pulvérisation de la cible précédente.

Dans des modes de réalisation préférés de la divulgation, on peut éventuellement avoir recours en outre à l'une et/ou à l'autre des dispositions suivantes :
- la couche présente une résistivité inférieure à 20µOhm.cm, préférentiellement inférieure à 17 µOhm.cm, pour une épaisseur de couche comprise entre 80 nm et 500 nm
- la couche présente une teneur en oxygène inférieure à 250 ppm, préférentiellement inférieure à 220 ppm.
- La couche présente une teneur en azote inférieure à 50 ppm, préférentiellement inférieure à 30 ppm
- La couche présente une teneur en fer inférieure à 50 ppm, préférentiellement inférieure à 40 ppm
- La couche présente une teneur en nickel inférieure à 10 ppm.
- La couche présente une teneur en chrome inférieure à 20 ppm.
- La couche présente une teneur en tungstène inférieure à 150 ppm.
- la couche comporte également au moins un élément d'addition choisi parmi le vanadium, le niobium, le tantale, le tungstène, le rhénium, le cuivre, le zirconium, le titane, le hafnium, le rhodium, la couche ayant 0,5 à 30% en poids de l'élément d'addition ou des éléments d'addition,

A titre d'exemples non limitatifs, l'invention peut être illustrée par les figures suivantes :
- les figures la 1b et 1c sont des vues montrant la microstructure en coupe d'une cible Mo obtenue par le procédé d'élaboration selon l'invention,
- Les figures 1 a et 1b montrent une structure très dense, les liaisons inter-particules étant difficiles à distinguer du fait de l'absence de lamelles d'oxydes.
- La figure 1c à fort grossissement permet de distinguer la structure lamellaire typique des procédés de projection thermique.
- Les figures 2a et 2b sont des vues montrant la microstructure en coupe d'une cible Mo obtenue par des procédés d'élaboration traditionnel respectivement par extrusion ou par frittage puis formage à chaud.

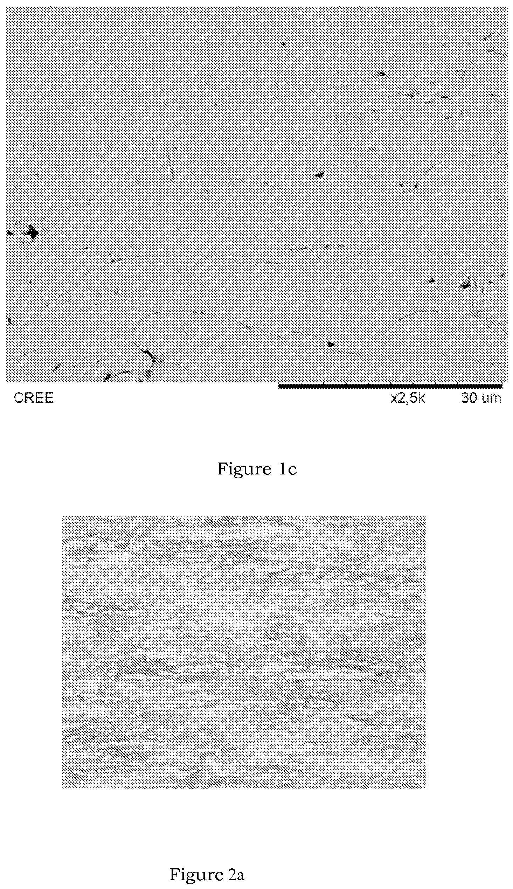

La figure 2a s'intéresse à une cible tubulaire, sa mise en forme à chaud (extrusion) avec texturation des grains unidirectionnelle selon le sens d'extrusion est bien révélée.

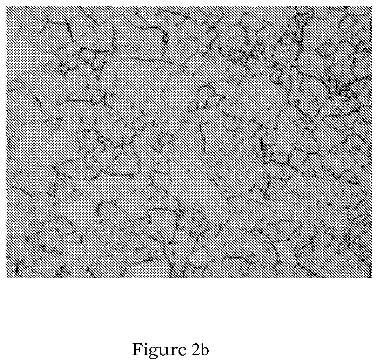

La figure 2b s'intéresse à une cible plane et sa microstructure est classique pour des microstructures de frittage.

D'autres caractéristiques et avantages de l'invention apparaîtront au cours de la description qui suit

### DESCRIPTION DETAILLEE DE L'INVENTION :

Le support sur lequel sera construite la cible peut être constitué de Cuivre, d'alliage cuivreux, d'acier inoxydable ou autre alliage habituellement compatible avec la réalisation de cibles magnétron. Dans la présente invention, aucune exigence particulière liée au procédé décrit dans l'invention n'est requise concernant le support si ce n'est qu'il devra répondre aux exigences habituelles concernant les cibles magnétron, exigences en termes de géométrie, résistance mécanique, inertie chimique vis-à-vis de l'eau de refroidissement.

### Préparation de surface du support

Après avoir été dégraissée, la surface du support est préparée par jet de grains abrasifs. Ces grains peuvent être de nature diverse : grains de Corindon (Alumine blanche fondue), de Corindon Brun, d'Abrasif Alumine-Zircone, d'abrasifs élaborés à partir de scories de fusion (type Vasilgrit), de grenat Almandine, ou encore de grenaille d'acier ou de fonte angulaire (liste non exhaustive).

Préférentiellement, les abrasifs suivants sont utilisés : Corindon (Alumine blanche fondue), Alumine-Zircone (Par exemple AZ 24 de Saint-Gobain Coating Solutions) (ce matériau est préféré pour sa haute ténacité qui limite la fracturation des grains et par voie de conséquence l'inclusion de fractions de grains dans la surface, inclusions néfastes pour l'adhérence du revêtement). Les diamètres moyens des grains d'abrasifs sont préférentiellement compris entre 180 et 800 µm selon le type d'abrasif. La finalité de cette opération est d'assurer une rugosité de surface apte à assurer une adhérence correcte de la sous-couche de liaison ou du composé à base de molybdène.

Une méthode alternative consiste à réaliser un usinage de stries qui permettra également une bonne adhérence de la sous-couche ou du composé molybdène.

### Réalisation d'une sous-couche de liaison par projection thermique

Afin d'optimiser l'adhérence mécanique de la couche fonctionnelle de la cible, une sous-couche de liaison peut être réalisée par projection thermique. Cette opération peut recourir aux procédés classiques de projection thermique parmi les procédés suivants : projection plasma (de poudre), projection à l'arc électrique (de fils), projection à flamme oxy-gaz (fil ou poudre selon équipements), projection par procédé HVOF (High Velocity Oxy Fuel), procédé de projection par canon à détonation, procédé de projection par gaz éventuellement préchauffé chargé de poudre (Cold spray). Cette opération peut être réalisée à l'air ambiant sans que cela ne nuise à l'invention.

Le matériau de sous-couche de liaison peut être choisi parmi les matériaux classiques utilisés couramment en tant que sous-couche :
- Ni ou alliages base Nickel : NiAl, NiCr, NiCrAl, Fe ou alliages ferreux : FeCrAl, Aciers FeCrC, FeMnC, aciers inoxydable austénitique X2CrNi18-9 ou du X2CrNiMo17-12-2, etc...
- Cu ou alliages Cuivreux tels que CuAl, CuAlFe, CuZn, ....
- Mo ou alliages de Mo : MoCu, etc..

La liste ci-dessus n'est pas exhaustive, le choix du matériau de sous-couche pouvant dépendre du matériau du tube support et de l'équipement de projection (et de la disponibilité du matériau d'apport sous la forme idoine).

### Construction de la couche fonctionnelle de la cible objet de l'invention, préférentiellement par projection plasma

La couche fonctionnelle de la cible est construite par projection plasma (plasma spraying), dans les conditions particulières suivantes :
- Projection plasma réalisée dans une enceinte dont l'atmosphère est « inerte », c'est-à-dire dont le taux d'oxygène et d'azote est bas, l'atmosphère étant constituée majoritairement de gaz neutre (Argon par exemple) et dont la pression est comprise entre 50 mbars et 1100 mbars
- Projection plasma utilisant un mélange de gaz plasmagènes réducteur qui permettra d'abaisser le taux d'oxygène initialement présent en surface des particules de poudre lors de leur fusion et en cours de vol vers le substrat
- Utilisation, au voisinage immédiat de la torche de projection plasma, de buses permettant le soufflage de jets puissants, cryogéniques liquides ou gazeux, d'un fluide inerte, les jets étant répartis autour de la torche
- Mouvements relatifs torche - cible permettant de moduler éventuellement les épaisseurs construites sur la cible et notamment aux extrémités de cette dernière par la réalisation de sur-épaisseurs communément appelées en anglais « dog-bone »
- Recours à un voire plusieurs injecteurs de poudre permettant une meilleure répartition de la poudre au sein de jet de plasma.
- Torche plasma pouvant être :
   ∘ Une torche plasma soufflé à courant continu disponible sur le marché
   ∘ Une torche plasma RF à couplage induction

La poudre utilisée pour réaliser la cible présente les caractéristiques typiques suivantes :
- Granulométrie définie telle que :
   ∘ D10% (diamètre tel que 10% des particules sont de taille inférieure à ce diamètre) compris entre 5 et 50 µm
   ∘ D50% (diamètre médian) compris entre 25 et 100 µm
   ∘ D90% (diamètre tel que 90% des particules sont de taille inférieure à ce diamètre) compris entre 40 et 200 µm
- Pureté conforme aux objectifs de pureté de la cible, préférentiellement supérieure à 99,95%
- Taux d'oxygène : < 1500 ppm, préférentiellement < 1000 ppm, voire < 500 ppm.

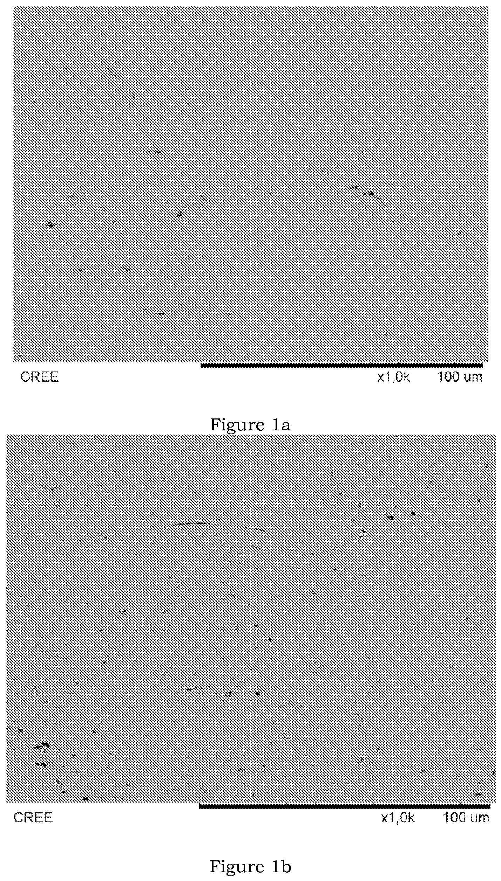

Le procédé objet de l'invention permet l'obtention d'une qualité de cible supérieure à celle obtenue classiquement par projection et présentant une structure lamellaire (cf figures 1a, 1b, 1c), notamment, pour les cibles en Molybdène pur :
- obtention d'une cible ayant un taux d'oxygène inférieur à 500 ppm directement, sans étape subséquente telle qu'un traitement thermique sous atmosphère réductrice à haute température.

Le fait de ne pas utiliser d'étape ultérieure de traitement thermique offre l'avantage d'utiliser tout type de matériau support (tube pour cible tubulaire ou support plan pour cibles planes) y compris les supports ayant un coefficient de dilatation nettement différent du Molybdène, tels que les aciers inoxydables austénitiques, ce qui serait proscrit dans le cas d'un traitement thermique subséquent visant à réduire le taux d'oxygène.

Bien entendu, un traitement thermique peut également être réalisé de manière optionnelle afin de réduire encore le taux d'oxygène dans la cible ainsi réalisée.

### Cas de cibles planes :

La présente invention permet de réaliser des cibles planes selon la procédure suivante :
- Support de cible plan, adapté au montage pour l'utilisation dans le magnétron
- Dans le cas où le support de cible est de forme complexe et doit être recyclable après usage de la cible, la construction du matériau cible ne sera pas réalisée directement sur le support de cible mais sur une ou plusieurs plaques intermédiaires (appelées « tuiles ») lesquelles seront liées sur le support.
- La construction du matériau cible (molybdène) sur le support ou sur la ou les tuile(s) sera réalisée en suivant le même procédé que ci-dessus.
- La liaison de la ou des tuile(s) pourra être effectuée avant construction du matériau cible (si la rigidité mécanique du support est importante) ou après construction du matériau cible sur les tuiles dans le cas où le support n'offre pas une rigidité suffisante. Dans ce dernier cas, les dimensions des tuiles seront déterminées de manière à minimiser les risques de déformation de celles-ci lors de l'opération de construction du matériau cible par projection plasma.

### EXEMPLE DE REALISATION :

L'exemple de réalisation concerne une cible tubulaire destinée à être utilisée en pulvérisation magnétron à cathode rotative. Le procédé suivant a été mis en œuvre :
- Tube support en acier inox austénitique comme par exemple du X2CrNi18-9 ou du X2CrNiMo17-12-2
- Préparation de surface du tube support par projection d'abrasif Alumine-Zircone AZ grit 24
- Réalisation de la sous-couche d'accrochage par le procédé Arc Electrique (Twin Arc wire spraying), réalisé sous air, sous-couche d'accrochage de composition NiAl (95% Nickel - 5% Aluminium). Dans l'exemple décrit, l'épaisseur de la sous-couche d'accrochage est de 200 µm nominal.
- Elaboration de la couche active de molybdène sur la cible par projection plasma dans les conditions suivantes :
∘ Torche plasma conférant des caractéristiques particulières de vitesse de jet de plasma et par conséquent de particules projetées
∘ Cible disposée dans une enceinte
∘ Utilisation de jets refroidisseurs cryogéniques dirigés vers la cible, répartis autour de la torche
∘ La poudre utilisée pour la réalisation de la cible est une poudre de Molybdène présentant les caractéristiques suivantes :
▪ Poudre de type agglomérée-frittée de Molybdène
▪ Granulométrie d₅₀ = 80 µm
▪ Pureté 99.95% avec notamment : 20 ppm de Fe et 600 ppm d'Oxygène

∘ Projection plasma menée avec les paramètres suivants :
▪ Une torche plasma avec les paramètres suivants ont été utilisés pour la réalisation de la cible de l'exemple :

| Paramètres | Débit Ar (slpm) | Débit H₂ (slpm) | Intensité d'arc (A) | Distance projection (mm) | Débit poudre (gr/min) |
|---|---|---|---|---|---|
| Valeurs utilisées | 50 | 14 | 600 | 160 | 160 |

∘ Finition de surface par polissage ou usinage pour obtention d'une rugosité telle que Rₘₐₓ< 15 µm

Comme indiqué précédemment, grâce au procédé spécifique objet de la présente invention, le taux d'Oxygène dans la cible obtenue est de 330 ppm, inférieur au taux de 600 ppm initialement présent dans la poudre. Les caractéristiques essentielles de la cible obtenue sont reprises dans le tableau suivant (cible Exemple n°4).

Des résultats complémentaires selon ce protocole avec des compositions différents de poudre et comparés à un résultat sans jet cryogénique selon l'invention sont présentés dans le tableau ci-dessous

| Ref Essai | Procédé | Taux d'O dans la poudre | Taux de N dans la poudre | Taux d'O dans la Cible | Taux de N dans la cible |
|---|---|---|---|---|---|
| A | Selon invention | 657 | 18 | 340 | 20 |
| B | Selon invention | 657 | 18 | 240 | 20 |
| C | Selon invention | 922 | 26 | 340 | 23 |
| D | Selon invention | 526 | 29 | 360 | 18 |
| E | Selon invention | 526 | 29 | 360 | 19 |
| F | Selon invention | 706 | 31 | 580 | 30 |
| G | Sans jets refroidisseurs | 560 | 29 | 960 | 83 |

Comme le montrent les résultats, le procédé de pulvérisation plasma avec jets refroidisseurs cryogéniques répartis autour de la torche plasma permet de réduire le taux d'oxygène dans la cible par rapport au taux d'oxygène dans la poudre de départ. Il est ainsi inutile de choisir une poudre de départ très pure, d'autant plus qu'il n'est possible, dans la pratique, d'éviter que la poudre ne contienne une certaine quantité d'oxygène. Le procédé selon l'invention est ainsi particulièrement avantageux.

### PROPRIETES ET AVANTAGES DE L'INVENTION

- Les cibles objet de la présente invention présentent les propriétés et avantages suivants :
   ∘ meilleur taux d'utilisation de la matière des cibles tubulaires obtenues par torche plasma par rapport à celles obtenues par les procédés de frittage puis formage à chaud du fait que le procédé objet de la présente invention offre la possibilité de déposer une surépaisseur en extrémité de cibles pour compenser la sur-érosion localisée dans les zones correspondant aux virages à faible rayon de courbure du champ magnétique créé par les cathodes et leurs aimants. Ceci permet d'atteindre des rendements matière de cibles supérieur à 75%, voir 80% alors que les rendements restent inférieurs à 75% sur des cibles à profil plat. Corolairement du fait de l'utilisation de ce type de cible, on obtient des couches, notamment à base de molybdène, dont le profil d'homogénéité de la Rcarré sur selon une dimension caractéristique du substrat à la surface duquel la couche est déposée ne dévie pas plus de
      +/- 2 % (par exemple sur un substrat de largeur de 3,20 m). Cette mesure est réalisée à l'aide d'un appareil de type « nagy » par mesure sans contact.
   ∘ Large gamme d'épaisseur de matériau sur la cible entre 1 et 25mm : on peut choisir l'épaisseur de la cible en fonction de la durée vie souhaitée de celle-ci (cette épaisseur étant en fait déterminée par la durée de production escomptée sans arrêt de ligne)
   ∘ dans le cas de cibles tubulaires, il est possible de polariser la cible en mode en AC (alternative current) ou DC (direct current) avec des puissances supérieures à 30 kW/m (gain en vitesse de dépôt), sans risque de fissuration par gradient thermique entre le tube support et la cible) ou de fusion de brasure.
   ∘ du fait de l'épaisseur de molybdène réduite à la valeur strictement nécessaire pour l'utilisateur, il est possible de limiter la tension nécessaire à soutenir la décharge à haute puissance et de rendre ainsi cette cible compatible avec les alimentations électriques magnétron courantes.

Dans le cas de cibles tubulaires ou planes monolithiques réalisées grâce à la présente invention, et par contraste avec les cibles comportant des segments assemblés, les risques suivants sont considérablement réduits :
∘ risque d'apparition de phénomène d'arcing qui génère des particules parasites, ainsi que le risque de désolidarisation de fragments du matériau cible de son support, qui est connu pour être une source de pollution des couches en molybdène.
∘ risque de pulvérisation du matériau de brasure ou du matériau du support de cible via les interstices entre segments.
∘ risque de défaillance thermique ou mécanique de la liaison (brasure ou colle conductrice) sur le support.

Les cibles objet de l'invention sont particulièrement destinées à être utilisée au sein d'une installation de dépôt de couche sous vide (magnétron en atmosphère neutre ou réactive, notamment par pulvérisation cathodique assistée par champ magnétique, par décharge couronne, ou par pulvérisation par source ionique), en vue de l'obtention d'une couche à base du matériau formant ladite cible, cette couche étant à base de molybdène.

Cette couche à base de molybdène peut être déposée directement sur un substrat ou indirectement sur une autre couche elle-même en contact d'un substrat, le substrat pouvant être de nature organique (PMMA, PC) ou inorganique (verre à base de silice, métal, ...).

Cette couche mince peut réaliser une électrode pour une cellule ou panneau photovoltaïque, ou bien entrer dans la constitution (interconnections, ...) d'écrans selon les technologies TFT, LCD, OLED, ILED, FED, ou tout autre ensemble requérant une couche mince de Molybdène de bonne qualité.

Les couches faisant l'objet des exemples suivants ont été obtenues par pulvérisation magnétron de différentes cibles obtenues selon l'état de l'art (exemples 1 et 3) et selon l'invention (exemples 4 à 5) :

| Exemples | Cibles magnétron | | | | | Procédé de dépôt | | couches minces Mo | |
|---|---|---|---|---|---|---|---|---|---|
| | Procédé | Epaisseur (mm) | O (ppm) | Fe (ppm) | Résistivité (µOhm.cm) | Puissanc e (kW/m) | Pression (µbar) | Epaisseur (nm) | Résistivité (µOhm.cm) |
| 1 | Frittage | 9 | < 50 | 60 | 5,6 | 30 (AC) | 4 | 88 | 19,6 |
| 2 | Frittage | 12,5 | < 50 | 50 | 6 | 10 (DC) | 4 | 180 | 18,8 |
| 3 | Plasma spray (art antérieur ) | 2,2 | > 700 | ? | - | 20 (DC) | 2 | 172 | 24,7 |
| 4 | Plasma spray | 9 | 330 | 9 | 8.4 | 30 (AC) | 4 | 88 | 19,0 |
| 5 | Plasma spray | 4 | 300 | 15 | 8.5 | 20 (DC) | 2 | 120 | 14,0 |

Les couches minces à base de molybdène ont été déposées sur un verre extra clair de 3 mm d'épaisseur, verre extra-clair SGG-Diamant.

Ces couches ont été déposées dans une machine de dépôt magnétron horizontal, munie d'une cible en molybdène selon l'invention, cette cible étant alimentée soit en mode AC soit en mode AC par une alimentation Hüttinger BIG150, soit en mode DC par une alimentation Pinnacle AE., sous un plasma d'argon de 450 sccm Argon, pour les exemples 1 et 4, et de 600 sccm d'argon pour les exemples 2, 3, et 5.

On remarque
- 4 versus 1 et 5 versus 2 : performances identiques ou meilleures entre la cible de l'invention et une cible de l'état de l'art de forte pureté. Pour une teneur en oxygène dans la cible < 450ppm, la teneur en oxygène (et donc la résistivité) dans la couche est gouvernée par le vide limite de l'enceinte de dépôt (quantité d'oxygène disponible dans la pression résiduelle)
- 5 versus 3 : meilleures performances entre la cible de l'invention et la cible selon l'art antérieur. Quand la teneur en oxygène dans la cible excède 500ppm, la teneur en oxygène dans la couche est gouvernée par la pureté de la cible.

Les cibles décrites dans les exemples 4 et 5 présentent un plasma parfaitement stable sous polarisation DC ou AC sans « arcing » significatif durant toute la vie de la cible.

En variante, si on pulvérise une cible obtenue éventuellement par le procédé selon l'invention, cette cible pouvant contenir au moins un cation métallique appartenant à la famille (Fe, Ni, Cr, W..), on obtient une couche présentant également une teneur en ces éléments.

La teneur en impuretés cationiques dans une couche mince réalisée à partir d'une cible rotative provient pratiquement uniquement de la cible. En effet, la technologie rotative élimine toute présence de pièces de fixation de la cible (« clamps ») et donc toute possibilité de pulvérisation parasite au-dessus du verre.

Dans la majorité des applications, la résistivité de la couche mince de Mo est notamment gouvernée par la teneur en oxygène dans le couche. Il est notamment important de minimiser cette teneur afin de conserver un niveau d'oxydation minimale de la couche et donc d'obtenir une résistivité proche de celle du molybdène métallique pur.

La teneur en oxygène dans la couche a 2 origines : (i) l'oxygène provenant de l'atmosphère résiduelle (« vide de base ») avant introduction du gaz de pulvérisation et (ii) l'oxygène provenant de la cible.

Ainsi, il est possible de calculer la quantité d'oxygène théoriquement incluse dans la couche de Molybdène et provenant de la pression partielle résiduelle en oxygène dans le coater. Soient :
J_{O2} (flux d'oxygène touchant le verre pendant le dépôt) = 3,51x10²²(m_{O2} xT)^{-1/2}xP où m_{O2} est la masse moléculaire du gaz oxygène, T la température en Kelvin et P la pression en Torr.

J_{Mo} (quantité de Mo sur le verre susceptible de réagir avec 02) = V_{Mo}xN_{Mo} où V_{Mo} est la vitesse de dépôt de Mo (en cm/s) et N_{Mo} la quantité d'atomes de Mo par cm³ dans une couche métallique magnétron (en atome/cm³).

S'il on considère que tout l'oxygène arrivant au contact du molybdène sur le substrat réagit, on peut calculer la teneur maximale en oxygène attendue dans la couche de Mo ; Pour une vitesse de dépôt constatée sur les coaters de 810⁻⁷ cm/s), on obtient des teneurs résiduelles en oxygène dans la couche de Mo en fonction de la pression partielle résiduelle en oxygène selon le tableau suivant :

| pO2 (mbar) dans l'atmosphère de pulvérisation | Teneur calculée en O provenant du vide dans la couche de Mo (ppm) |
|---|---|
| 10⁻⁷ | 1000 |
| 5.10⁻⁸ | 540 |
| 2.10⁻⁸ | 250 |
| 1.10⁻⁸ | 110 |
| 5.10⁻⁹ | 54 |

La pression partielle résiduelle minimale mesurée dans le coater est classiquement de 5.10^{E}-8 mbar, soit environ 540 ppm théorique d'oxygène. On voit donc qu'il est inutile d'utiliser des cibles de pureté en oxygène très inférieure à 540 ppm car l'influence de la cible sur la pureté de la couche finale est masquée par l'oxygène provenant de l'atmosphère du coater. L'invention consiste à choisir une technologie de réalisation de cibles de Mo magnétron moins couteuse dont la teneur en oxygène est inférieure à 1000 ppm, préférentiellement inférieure à 600 ppm, et de manière encore plus préférentielle inférieure à 450 ppm.

La teneur résiduelle en cations métalliques (Fe, Ni, Cr, W..) de la couche mince de Mo obtenue dans le cadre de l'invention est inférieure à celle des couches obtenues par des cibles traditionnelles pour 2 raisons :
- la couche de l'invention est obtenue par pulvérisation d'une cible monolithique (1 seul segment) : pas de risque de pulvérisation du backing-tube (Ti ou Inox) ou de la matière utilisée pour le bonding du Mo sur le backing-tube (par exemple In).
- La couche de l'invention est obtenue par pulvérisation d'une cible de grande pureté en cations métalliques. Ceci est relié au choix de la technologie de réalisation de la cible et à sa mise en œuvre : choix d'une poudre de matière première de haute pureté et mise en forme de la cible par plasma spray, i.e. sans contact direct du molybdène projeté avec des pièces métalliques comme dans les techniques d'extrusion ou de laminage à chaud ou des contacts avec des pièces métalliques à base d'acier ou d'inox, de tungstène etc... sont possibles.

La couche en molybdène selon l'invention contient typiquement :
- une teneur en fer inférieure à 50 ppm, préférentiellement inférieure à 40 ppm, et/ou
- une teneur en nickel inférieure à 10 ppm, et/ou
- une teneur en chrome inférieure à 20 ppm, et/ou
- une teneur en tungstène inférieure à 150 ppm.

## Revendications

1. Procédé de réalisation d'une cible par projection plasma au moyen d'une torche plasma, ladite cible étant en molybdène, **caractérisé en ce qu'**on projette par projection plasma sur au moins une portion de surface de la cible, au moins une fraction du molybdène sous forme de poudre, réalisée au sein d'une enceinte ayant été purgée ou rincée puis remplie du gaz inerte, jusqu'à une pression pouvant aller de 50 mbars à 1100 mbars, de manière à créer en son sein une atmosphère appauvrie en oxygène, **en ce que** le mélange de gaz plasmagène utilisé est réducteur, et **en ce qu'**on utilise des jets refroidisseurs cryogéniques puissants à une température égale ou inférieure à -150°C dirigés vers la cible pendant sa construction et répartis autour de la torche, de sorte que le taux d'oxygène présent dans la cible sous forme d'oxyde est inférieur de plus de 5% relatifs à celui initialement présent dans la poudre de départ.

2. Procédé selon la revendication 1, **caractérisé en ce que** la composition du mélange plasmagène comporte plus de 10 % d'Hydrogène ou un autre gaz plasmagène réducteur.

3. Procédé selon l'une quelconque des revendications 1 ou 2, **caractérisé en ce qu'**une sous couche d'accrochage est déposée avant projection plasma du molybdène au niveau de la portion de surface de la cible concernée.

4. Procédé selon l'une quelconque des revendications 1 à 3, **caractérisé en ce qu'**on procède à une régulation thermique de la cible lors de la projection plasma.

5. Procédé selon l'une des revendications 1 à 4, **caractérisé en ce que** la poudre de molybdène a une granulométrie 5 µm< D₁₀ < 50 µm ; 25 µm < D₅₀ < 100 µm et 40 µm < D₉₀ < 200 µm.

6. Cible, destinée à être utilisée dans les procédés de dépôt sous vide, d'épaisseur nominale (e) comprise entre 1 et 25 mm, en molybdène susceptible d'être obtenue par le procédé selon l'une quelconque des revendications 1 à 5, **caractérisée en ce qu'**elle présente :
- une microstructure lamellaire,
- un taux d'oxygène inférieur à 600 ppm, préférentiellement inférieur à 450 ppm, et
- une résistivité électrique inférieure à 5 fois, de préférence 3 fois, de préférence encore à 2 fois la résistivité électrique théorique du molybdène de 5,34 µOhm.cm.

7. Cible selon la revendication 6, **caractérisée en ce que** la cible est de géométrie plane ou tubulaire.

8. Cible selon l'une quelconque des revendications 6 ou 7, **caractérisée en ce que** la cible présente une densité supérieure à 85 %, préférentiellement supérieure à 90 %.

9. Cible selon l'une quelconque des revendications 6 à 8, **caractérisée en ce que** l'épaisseur nominale (e) est comprise entre 6 et 14 mm.

10. Cible selon l'une quelconque des revendications 6 à 9, **caractérisée en ce que** la cible présente une teneur en fer inférieure à 50 ppm, préférentiellement inférieure à 35 ppm.

11. Cible selon l'une quelconque des revendications 6 à 10, **caractérisée en ce que** la cible présente une pureté d'au moins 99,95 %.

12. Procédé de réalisation d'une couche à base de molybdène, notamment en molybdène, comprenant la pulvérisation d'une cible selon l'une des revendications 6 à 11.

## Patentansprüche

1. Verfahren zur Herstellung eines Targets durch Plasmaspritzen unter Verwendung eines Plasmabrenners, wobei das Target aus Molybdän besteht, **dadurch gekennzeichnet, dass** durch Plasmaspritzen auf mindestens einem Oberflächenabschnitt des Targets mindestens eine Fraktion des Molybdäns in Pulverform gespritzt wird, das innerhalb eines Einschlusses, der entlüftet oder gespült und dann mit Inertgas gefüllt wurde, bis zu einem Druck, der von 50 mbar bis 1100 mbar reichen kann, ausgeführt wird, dass in seinem Inneren eine sauerstoffarme Atmosphäre geschaffen wird, dass das verwendete plasmabildende Gasgemisch reduzierend ist, und dass starke kryogene Kühlstrahlen mit einer Temperatur von gleich oder kleiner als -150 °C verwendet werden, die während seines Aufbaus auf das Target gerichtet sind, und die um den Brenner derart verteilt sind, dass der Sauerstoffgehalt, der in dem Target in Form von Oxid vorhanden ist, um mehr als 5 % kleiner ist als der ursprünglich im Ausgangspulver vorhandene.

2. Verfahren nach Anspruch 1, **dadurch gekennzeichnet, dass** die Zusammensetzung des plasmabildenden Gemischs mehr als 10 % Wasserstoff oder ein anderes reduzierendes plasmabildendes Gas umfasst.

3. Verfahren nach einem der Ansprüche 1 oder 2, **dadurch gekennzeichnet, dass** vor dem Plasmaspritzen des Molybdäns in dem Bereich des Oberflächenabschnitts des betreffenden Targets eine Bindungsschicht aufgebracht wird.

4. Verfahren nach einem der Ansprüche 1 bis 3, **dadurch gekennzeichnet, dass** während des Plasmaspritzens eine Wärmeregulierung des Targets vorgenommen wird.

5. Verfahren nach einem der Ansprüche 1 bis 4, **dadurch gekennzeichnet, dass** das Molybdänpulver eine Korngröße 5 µm <D₁₀<50 µm; 25 µm<D₅₀<100 µm und 40 µm<D₉₀<200 µm aufweist.

6. Target, das dazu bestimmt ist, bei den Vakuumabscheidungsprozessen verwendet zu werden, mit einer Nennstärke (e) zwischen 1 und 25 mm, aus Molybdän, das durch das Verfahren nach einem der Ansprüche 1 bis 5 erhalten werden kann, **dadurch gekennzeichnet, dass** es aufweist:
- eine lamellare Mikrostruktur,
- einen Sauerstoffgehalt kleiner als 600 ppm, vorzugsweise kleiner als 450 ppm, und
- einen spezifischen elektrischen Widerstand kleiner als das Fünffache, vorzugsweise das Dreifache, noch bevorzugter das Zweifache des theoretischen spezifischen elektrischen Widerstands von Molybdän von 5,34 µOhm.cm.

7. Target nach Anspruch 6, **dadurch gekennzeichnet, dass** das Target eine flache oder rohrförmige Geometrie aufweist.

8. Target nach einem der Ansprüche 6 oder 7, **dadurch gekennzeichnet, dass** das Target eine Dichte größer als 85 %, vorzugsweise größer als 90 % aufweist.

9. Target nach einem der Ansprüche 6 bis 8, **dadurch gekennzeichnet, dass** die Nennstärke (e) zwischen 6 und 14 mm liegt.

10. Target nach einem der Ansprüche 6 bis 9, **dadurch gekennzeichnet, dass** das Target einen Eisengehalt kleiner als 50 ppm, vorzugsweise kleiner als 35 ppm aufweist.

11. Target nach einem der Ansprüche 6 bis 10, **dadurch gekennzeichnet, dass** das Target eine Reinheit von mindestens 99,95 % aufweist.

12. Verfahren zur Herstellung einer Schicht auf Basis von Molybdän, insbesondere aus Molybdän, das das Spritzen eines Targets nach einem der Ansprüche 6 bis 11 umfasst.

## Claims

1. A process for producing a target by plasma spraying by means of a plasma torch, said target being in molybdenum, **characterized in that** at least one fraction of molybdenum in the form of powder is sprayed by plasma spraying onto at least one surface portion of the target, in a chamber that has been purged or rinsed and then filled with inert gas, up to a pressure that may range from 50 mbar to 1100 mbar, so as to create an oxygen-depleted atmosphere within it, **in that** the plasma gas mixture used is reducing, and **in that** powerful cryogenic cooling jets at a temperature equal to or below -150°C directed onto the target during its construction and distributed around the torch are used, so that the oxygen content present in the target in oxide form is more than 5% less than that initially present in the starting powder.

2. The process as claimed in claim 1, **characterized in that** the composition of the plasma gas mixture comprising more than 10% hydrogen or another reducing plasma gas.

3. The process as claimed in any one of claims 1 or 2, **characterized in that** a keying sublayer is deposited, before thermal spraying of said compound, on the surface portion of the target in question.

4. The process as claimed in any one of claims 1 to 3, **characterized in that** the target is thermally regulated during the plasma spraying.

5. The process as claimed in one of claims 1 to 4, **characterized in that** the molybdenum powder has a particle size distribution 5 < D₁₀ < 50 µm; 25 µm < D₅₀ < 100 µm; and 40 µm < D₉₀ < 200 µm.

6. A target, intended to be used in a vacuum sputtering process, having a nominal thickness (e) between 1 and 25 mm, in molybdenum obtainable by the process according to any one of claims 1 to 5, **characterized in that** it has:
- a lamellar microstructure;
- an oxygen content of less than 600 ppm, preferably less than 450 ppm; and
- an electrical resistivity less than five times, preferably three times and more preferably twice the theoretical electrical resistivity of the molybdenum of 5,34 µOhm.cm.

7. The target as claimed in claim 6, **characterized in that** it has a planar or tubular geometry.

8. The target as claimed in any one of claims 8 or 7, **characterized in that** it has a density of greater than 85%, preferably greater than 90%.

9. The target as claimed in any one of claims 6 to 8, **characterized in that** the nominal thickness (e) is between 6 and 14 mm.

10. The target as claimed in any one of claims 6 to 9, **characterized in that** the target has an iron content of less than 50 ppm, preferably less than 35 ppm.

11. The target as claimed in any one of claims 6 to 10, **characterized in that** the target has a purity of at least 99.95%.

12. A process for producing a molybdenum-based film, especially a molybdenum film, comprising sputtering a target according to any one of claims 6 to 11.
